(19) Europäisches Patentamt
European Patent Office
Office européen des brevets

(11) **EP 4 660 428 A1**

(12) **EUROPEAN PATENT APPLICATION**

(43) Date of publication:
**10.12.2025 Bulletin 2025/50**

(21) Application number: **25175371.1**

(22) Date of filing: **09.05.2025**

(51) International Patent Classification (IPC):
**F01N 3/20** (2006.01)     **F01N 9/00** (2006.01)

(52) Cooperative Patent Classification (CPC):
**F01N 3/208; F01N 9/005;** F01N 2900/0402;
F01N 2900/1812

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **03.06.2024 US 202418731776**

(71) Applicant: **GE Vernova Technology GmbH
5400 Baden (CH)**

(72) Inventors:
• **BHATT, Abhishek
500081 Hyderabad (IN)**
• **AKABOGU, Alexander
Schenectady, 12345 (US)**

(74) Representative: **Rüger Abel Patentanwälte
PartGmbB
Webergasse 3
73728 Esslingen a. N. (DE)**

(54) **CONTROL OF SELECTIVE CATALYTIC REDUCTION USING MACHINE LEARNING**

(57)     A method includes obtaining, by a computing system comprising a machine-learned model (104), input data comprising one or more input values (102). The method includes generating, by the machine-learned model (104) based on the input data (102), output data (106) indicative of an amount (106) of a reactant (110). The method includes providing a signal, by the computing system, to cause the amount (106) of the reactant (110) to be provided to a selective catalytic reduction system (112).

Input Data **102**

↓

Machine Learning System **104**

Reactant Amount Predictions **106**

↓

Reactant Flow Control System **108**

Reactant **110**

↓

Catalytically Reduced Emissions **116**

Industrial System **114**

Selective Catalytic Reduction System **112** → Exhaust System **118**

**FIG. 1**

**Description**

FIELD

The present disclosure relates generally to selective catalytic reduction of emissions. More particularly, the present disclosure relates to systems and methods for using machine learning to control a selective catalytic reduction system.

BACKGROUND

Selective catalytic reduction is a process in which a reactant (e.g., ammonia, urea, etc.) can be used to convert one or more input compounds (e.g., gases such as NO, $NO_2$, etc.) into one or more output compounds (e.g., common atmospheric gases such as pure nitrogen, water vapor, etc.). In some instances, a catalytic reduction process can include providing a reactant (e.g., liquid reactant such as ammonia, urea, diesel exhaust fluid, etc.) to a catalytic reduction system (e.g., via a catalyst bed or catalyst chamber). In some instances, optimizing a selective catalytic reduction process can include optimizing an amount of reactant provided. For example, providing too much reactant can cause reactant slip (e.g., ammonia slip, etc.), wherein a reactant may be unintentionally emitted from a catalyst chamber without causing a conversion of the input compounds. As another example, providing too little reactant may cause a percentage of the input compounds to be emitted from the catalyst chamber without being converted into output compounds.

BRIEF DESCRIPTION

Aspects and advantages of the systems and methods in accordance with the present disclosure will be set forth in part in the following description, or may be obvious from the description, or may be learned through practice of the technology.

In accordance with one embodiment, a method is provided. The method includes obtaining, by a computing system comprising a machine-learned model, input data comprising one or more input values. The method includes generating, by the machine-learned model based on the input data, output data indicative of an amount of a reactant. The method includes providing a signal, by the computing system, to cause the amount of the reactant to be provided to a selective catalytic reduction system.

In accordance with another embodiment, a method is provided. The method includes obtaining, by a self-adjusting reactant flow control system, emissions data indicative of one or more emissions amounts. The method includes adjusting, by the self-adjusting reactant flow control system based on the emissions data, a first amount of reactant provided to a selective catalytic reduction system. The method includes monitoring, by a computing system comprising one or more computing devices, the adjusting. The method includes determining that the first amount of the reactant provided to the selective catalytic reduction system has stabilized. The method includes training, by the computing system using one or more data examples comprising data indicative of the stabilized first amount, a machine-learned model.

In accordance with another embodiment, a computing system is provided. The computing system includes one or more processors. The computing system includes one or more non-transitory computer-readable media that collectively store a machine-learned model and instructions that, when executed by the one or more processors, cause the computing system to perform operations. The operations include obtaining input data comprising one or more input values. The operations include generating, by the machine-learned model based on the input data, output data indicative of an amount of a reactant. The operations include providing a signal to cause the amount of the reactant to be provided to a selective catalytic reduction system.

These and other features, aspects and advantages of the present systems and methods will become better understood with reference to the following description and appended claims. The accompanying drawings, which are incorporated in and constitute a part of this specification, illustrate embodiments of the technology and, together with the description, serve to explain the principles of the technology.

BRIEF DESCRIPTION OF THE DRAWINGS

A full and enabling disclosure of the present systems and methods, including the best mode of making and using the present systems and methods, directed to one of ordinary skill in the art, is set forth in the specification, which makes reference to the appended figures, in which:

FIG. 1 is a block diagram of a system for selective catalytic reduction using machine learning in accordance with embodiments of the present disclosure;
FIG. 2 is a block diagram of a system for training a machine learning system for controlling a selective catalytic reduction system in accordance with embodiments of the present disclosure;

FIG. 3 is a block diagram of a machine learning system for controlling a selective catalytic reduction system in accordance with embodiments of the present disclosure;

FIG. 4 is a block diagram of a system for controlling a selective catalytic reduction system using machine learning, while continuously training the machine learned control system during operation in accordance with embodiments of the present disclosure;

FIG. 5 is a flowchart diagram of an example method for controlling a selective catalytic reduction system using machine learning in accordance with embodiments of the present disclosure;

FIG. 6 is a flowchart diagram of an example method for training a machine learning system in accordance with embodiments of the present disclosure; and

FIG. 7 is a block diagram of an example computing system for performing various operations in accordance with embodiments of the present disclosure.

DETAILED DESCRIPTION

Reference now will be made in detail to embodiments of the present systems and methods, one or more examples of which are illustrated in the drawings. Each example is provided by way of explanation, rather than limitation of, the technology. In fact, it will be apparent to those skilled in the art that modifications and variations can be made in the present technology without departing from the scope or spirit of the claimed technology. For instance, features illustrated or described as part of one embodiment can be used with another embodiment to yield a still further embodiment. Thus, it is intended that the present disclosure covers such modifications and variations as come within the scope of the appended claims and their equivalents.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The detailed description uses numerical and letter designations to refer to features in the drawings. Like or similar designations in the drawings and description have been used to refer to like or similar parts of the invention. As used herein, the terms "first", "second", and "third" may be used interchangeably to distinguish one component from another and are not intended to signify location or importance of the individual components.

The term "fluid" may be a gas or a liquid. The term "fluid communication" means that a fluid is capable of making the connection between the areas specified.

Terms of approximation, such as "about," "approximately," "generally," and "substantially," are not to be limited to the precise value specified. In at least some instances, the approximating language may correspond to the precision of an instrument for measuring the value, or the precision of the methods or machines for constructing or manufacturing the components and/or systems. In at least some instances, the approximating language may correspond to the precision of an instrument for measuring the value, or the precision of the methods or machines for constructing or manufacturing the components and/or systems. For example, the approximating language may refer to being within a 1, 2, 4, 5, 10, 15, or 20 percent margin in either individual values, range(s) of values and/or endpoints defining range(s) of values. When used in the context of an angle or direction, such terms include within ten degrees greater or less than the stated angle or direction. For example, "generally vertical" includes directions within ten degrees of vertical in any direction, e.g., clockwise or counter-clockwise.

As used herein, the terms "comprises," "comprising," "includes," "including," "has," "having" or any other variation thereof, are intended to cover a non-exclusive inclusion. For example, a process, method, article, or apparatus that comprises a list of features is not necessarily limited only to those features but may include other features not expressly listed or inherent to such process, method, article, or apparatus. Further, unless expressly stated to the contrary, "or" refers to an inclusive- or and not to an exclusive- or. For example, a condition A or B is satisfied by any one of the following: A is true (or present) and B is false (or not present), A is false (or not present) and B is true (or present), and both A and B are true (or present).

Here and throughout the specification and claims, range limitations are combined and interchanged, such ranges are identified and include all the sub-ranges contained therein unless context or language indicates otherwise. For example, all ranges disclosed herein are inclusive of the endpoints, and the endpoints are independently combinable with each other.

Overview

The present disclosure is generally directed to systems and methods for machine-learned control of selective catalytic reduction systems. More particularly, the present disclosure is directed to systems and methods for training a machine-learned model to predict an optimal or near optimal amount of reactant to be provided to a particular system (e.g., a particular machine, plant, device, turbine, catalyst chamber, etc.) based on past performance of that particular system.

For example, a system can include a self-adjusting catalytic flow control component such as a proportional-integral-derivative (PID) controller, which can automatically adjust a flow of reactant based on sensor data (e.g., emissions data collected from an emissions stack, etc.). Upon one or more changes to the system (e.g., change in turbine load or other operating variable of a gas turbine system, etc.), the self-adjusting control system may repeatedly (e.g., continuously, etc.) adjust the reactant flow until it converges on an optimal flow value. Upon convergence, the optimal flow value can be stored as a training data example, along with additional input data that may be relevant to predicting an optimal reactant flow (e.g., emissions data, reactant slip data, ambient conditions, flue gas temperature, system load such as turbine load, duct burner fuel flow, etc.). The training examples can be used to perform machine-learned predictions of optimal flow values for a particular system, based on data examples collected from that particular system.

In some instances, an example machine learning algorithm for predicting optimal flow can include non-parametric or semi-parametric machine learning. For example, in some instances, the collected data examples can be stored in a data structure correlating various input data values with a corresponding optimal flow value. A machine learning system can retrieve, based on input data corresponding to a current state of the catalytic reduction system, a plurality of data examples indicative of past optimal flow values associated with similar system states. The machine learning system can predict, based on the retrieved data examples, an optimal reactant flow value for the current state of the system. Various methods (e.g., statistical methods, machine learning methods, etc.) can be used to combine data examples to generate a prediction, such as parametric, nonparametric, or semiparametric regression; linear, polynomial, or other interpolation; etc. As a simplified illustrative example, a machine-learning system predicting optimal flow based on one input variable could receive an input value; retrieve two or more data examples associated with similar input values; and perform linear regression or linear interpolation between the data examples to generate an output. Similar methods can be adapted to predict optimal flow based on input data comprising a plurality of input variables (e.g., plurality of input variables associated with a gas turbine system, such as turbine load; flue gas temperature; duct burner fuel flow; ambient conditions such as temperature, etc.; emissions sensor data such as NOx data or reactant slip data; startup or shutdown status data; or other relevant data).

In some instances, a machine-learned flow control system can continuously self-calibrate using a selective forgetting process. For example, the machine-learned flow control system can continue to collect additional training data while a machine-learned flow control system is in operation, and can periodically remove obsolete data from a training data structure. For example, a machine-learned model can predict an optimal reactant flow; the predicted reactant flow amount can be provided throughout a latency period (e.g., associated with a latency of emissions data); and after the latency period, a self-adjusting flow control system can determine a true optimal flow based on emissions data. If the true optimal flow is significantly different from the predicted flow (e.g., according to an error threshold, etc.), a new training data example can be added based on the true optimal flow. Responsive to a new training data example being added to a training data structure, one or more older data examples can be determined to be obsolete (e.g., based on age of the data examples, etc.), and can be removed from the training data structure. **In** this manner, for instance, a machine-learned flow control system can be continuously recalibrated as a system (e.g., selective catalytic reduction system, turbine system, etc.) ages, undergoes maintenance, or otherwise experiences changes that may alter its operating behavior.

An example field of application for some provided systems and methods can include industrial turbine applications. For example, an industrial turbine system can include a gas turbine; a heat recovery steam generator comprising a selective catalytic reduction system; an emissions stack; and one or more sensors for monitoring stack emissions (e.g., $NO_x$ emissions, etc.). In some instances, calibrating such a system via traditional methods (e.g., using PID controllers, etc.) can be challenging due to a long latency period (e.g., several minutes, etc.) between a time when a change in system operation is made (e.g., change in turbine load, duct burner fuel flow, reactant flow amount, etc.) or detected (e.g., ambient conditions, etc.) and a time when a corresponding effect of the change on emissions can be detected (e.g., by a sensor associated with the emissions stack, etc.). Advantageously, some provided systems and methods can predict an optimal flow amount earlier than some alternative methods, thereby providing improved catalytic reduction and reducing an amount of unwanted emissions (e.g., $NO_x$, ammonia slip, etc.).

In some instances, example machine-learned flow predictions can be combined with other methods for controlling a selective catalytic reduction system (e.g., in a turbine-based industrial system, etc.). For example, in some instances, a selective catalytic reduction system can behave one way during continuous operation of a turbine system, and can behave differently during a shutdown or startup period (e.g., one hour before shutdown, one hour after startup, etc.). In some instances, machine-learned flow control can include one or more adjustments for such a startup or shutdown period. For example, in some instances, a reactant flow multiplier can be used to adjust a reactant flow during startup and shutdown. For example, a reactant flow may be stopped (e.g., reduced to zero) or greatly reduced before shutdown (e.g., one hour before shutdown, etc.) to prevent reactant slip upon startup. As another example, a reactant flow multiplier may be ramped up (e.g., from zero to one) during a startup time window. In some instances, controlling a reactant flow during startup or shutdown can include predicting, using a machine-learned system, a predicted reactant amount; determining, by a computing system, a reactant multiplier based on a time to shutdown or startup; and providing a selective catalytic reduction system with an amount of reactant equal to the predicted reactant amount times the reactant multiplier.

Systems and methods according to example aspects of the present disclosure can provide various technical effects and benefits, such as improvements in emissions-related outcomes of a selective catalytic reduction system (e.g., reduced ammonia slip, reduced $NO_x$ emissions, improved regulatory compliance, reduced cost of compliance, etc.) and improvements in the functioning of a computing system executing a machine-learned model (e.g., reduced memory footprint, reduced training data requirement, reduced computational costs, etc.).

For example, some alternative methods (e.g., PID-based methods) of reactant flow control may suffer from a long latency period (e.g., several minutes) between a time when a system change is made (e.g., PID-based adjustment to reactant flow, etc.) and a time when an effect of the change can be detected (e.g., via emissions sensors). In some instances, a system may require several cycles of change and delayed feedback (e.g., cycles of over-correction, under-correction, etc.) before finally converging on an optimal solution. In systems where each feedback cycle may take several minutes (e.g., four minutes, etc.), these repeated cycles of delayed feedback may cause a control system to provide suboptimal amounts of reactant for long periods of time before converging on an optimal amount. Advantageously, systems and methods according to some aspects of the present disclosure can predict an optimal reactant amount more quickly than some alternative control systems.

As another example, some industrial systems (e.g., turbine systems, etc.) and selective catalytic reduction systems may change their operating behavior over time for a variety of reasons, such as equipment aging; equipment maintenance or replacement; system modifications; system operator behavior; etc. Additionally, individual industrial systems and selective catalytic reduction systems may behave differently from other, similar systems. Some alternative methods may fail to account for differences between systems or differences within a particular system over time. Advantageously, systems and methods according to some aspects of the present disclosure can predict an optimal flow value for a particular system, and can adjust to changing operating behavior of that system over time. In this manner, for instance, prediction accuracy can be increased, and a more optimal reactant flow can be provided for a particular system over time. A more optimal reactant flow can, in turn, provide for reduced emissions (e.g., ammonia slip, $NO_x$ emissions, etc.), improved regulatory compliance, and improved cost of compliance.

Systems and methods according to some aspects of the present disclosure can also provide for improved functioning of a computing system executing the machine-learned model. For example, in some instances, provided systems and methods can predict an optimal reactant flow using less training data compared to some alternative methods. For example, in some instances, a training data structure comprising just 32 data examples can be sufficient to model a complex non-linear relationship between an input variable (e.g., turbine load) and an optimal flow amount. Predicting optimal flow based on less training data can provide a variety of technical effects and benefits, such as reduced memory footprint; reduced cost of data collection; and a shorter data collection period. For example, a shorter data collection period can allow a machine-learned control system to be installed or calibrated more quickly compared to some alternative methods, thereby providing earlier improvements in emissions and regulatory compliance.

Additionally, systems and methods according to some example aspects of the present disclosure can provide machine-learned inference at a reduced computational cost (e.g., memory usage, processor usage, electricity cost, etc.). For example, some alternative machine-learned methods may use neural networks. In some instances, performing inference with a neural network may require a large number (e.g., thousands, millions, billions, etc.) of floating-point operations associated with a large number of neural network parameters. In contrast, example systems and methods according to some aspects of the present disclosure can use a small number of operations to perform inference based on a small number of retrieved data examples. In this manner, for instance, a computational cost of machine-learned inference can be reduced, and the functioning of the computing system itself can be improved.

As another example, some alternative methods may use machine-learned methods to predict, based on a reactant flow amount as input, a predicted emissions amount (e.g., $NO_x$ emissions prediction, etc.) as output. However, determining an optimal reactant flow using such an alternative method may require multiple machine-learned inference computations. For example, determining an optimal reactant flow may require selecting a plurality of candidate flow amounts; predicting a plurality of emissions amounts associated with the plurality of candidate flow amounts; and determining, based on a comparison between the plurality of emissions predictions, an amount of reactant to be provided to a selective catalytic reduction system. In contrast, example systems and methods according to some aspects of the present disclosure can directly predict an optimal flow amount using only one machine-learned inference computation, thereby reducing a computational cost (e.g., processor usage, electricity cost, etc.) of selecting an optimal reactant flow amount. In this manner, for instance, a computational cost of machine-learned inference can be reduced, and the functioning of the computing system itself can be improved compared to some alternative methods.

Example Systems

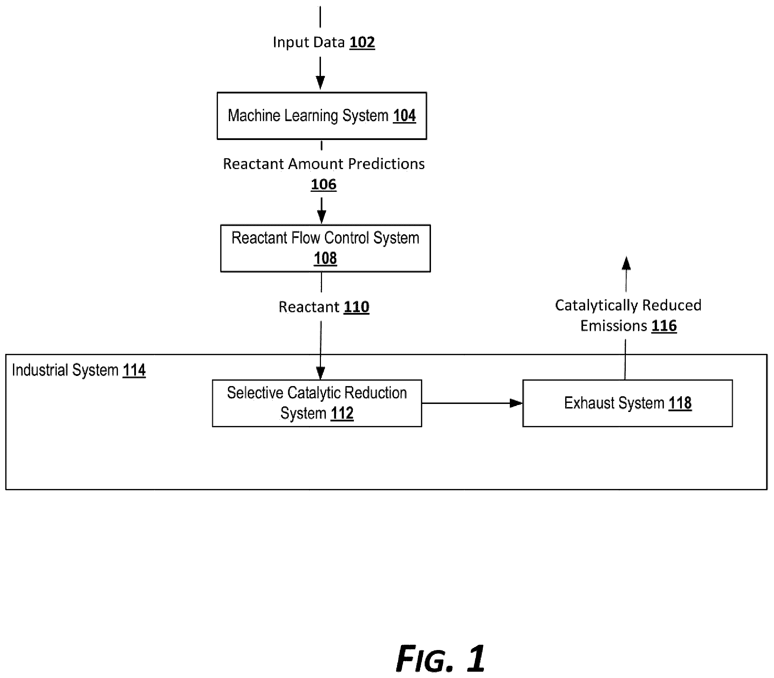

Referring now to the drawings, FIG. 1 illustrates a block diagram of a system for selective catalytic reduction using machine learning in accordance with embodiments of the present disclosure. A machine learning system 104 can receive input data 102, and can output one or more reactant amount predictions 106 based on the input data 102. Based on the reactant amount predictions 106, a reactant flow control system 108 can provide an amount of reactant 110 to a selective catalytic reduction system 112 of an industrial system 114. The selective catalytic reduction system 112 can process emissions of the industrial system 114 to generate catalytically reduced emissions 116 to be emitted via an exhaust system 118.

The input data 102 can include, for example, any data relevant to estimating an optimal reactant flow for a selective catalytic reduction system 112. For example, input data 102 associated with a turbine-based industrial system 114 may include data indicative of a turbine load; flue gas temperature; duct burner fuel flow; ambient conditions (e.g., temperature, etc.); emissions sensor data (e.g., $NO_x$ data,. reactant slip data, etc.); startup or shutdown status data or other turbine status data; or any other relevant data. Input data 102 associated with other systems may include similar kinds of data (e.g., load, temperature, fuel flow, emissions data, etc.) or different kinds of data. The input data 102 can include snapshot data from a single time point, or can include time series data from a plurality of times. The input data 102 can include one type or many types of data. For example, in some instances, the input data 102 can include numerical (e.g., floating point, etc.) data indicative of one or more numerical quantities (e.g., turbine load, flue gas temperature, fuel flow, ambient temperature, emissions, etc.).

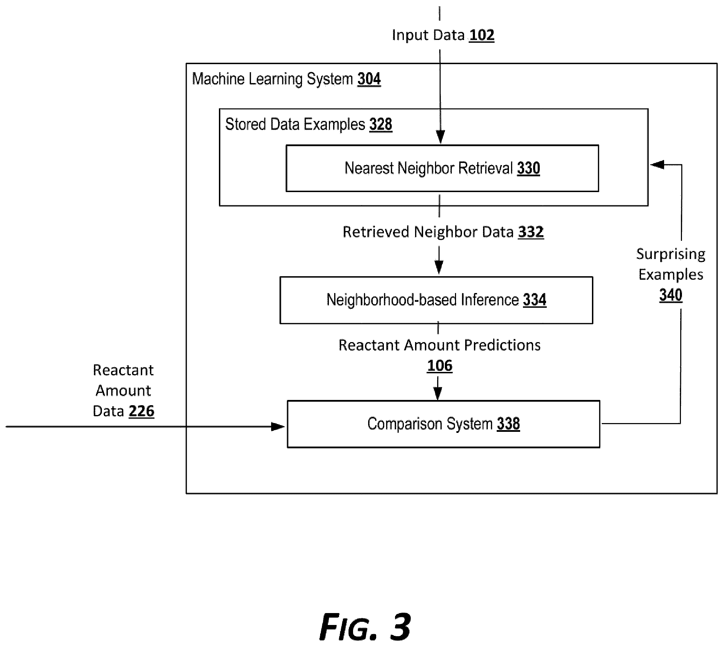

A machine learning system 104 can include various machine learning architectures, and can include one type or many types of machine learning architectures. A machine learning system 104 can use parametric learning techniques (e.g., neural networks, etc.) or nonparametric learning techniques (e.g., nearest neighbors, etc.); sequence-based techniques (e.g., attention-based techniques, convolutional techniques, recurrent or long short-term memory techniques, etc.) for predicting optimal reactant flow based on time series data or non-sequence techniques for predicting reactant flow based on input data 102 from a single time. In some instances, a machine learning system 104 can include a retrieval-based machine learning system, wherein relevant data (e.g., historical data correlating past input data 102 with past optimal reactant flow rates, etc.) can be retrieved by the machine learning system at inference time. Example details of an example machine learning system 104 are further described below with respect to FIG. 3.

The reactant amount predictions 106 can be, for example, machine-learned predictions of an optimal amount of a reactant 110 to be provided to a selective catalytic reduction system 112. In some instances, the reactant amount predictions 106 can include a final reactant flow value, and the reactant flow control system 108 can provide an amount of reactant 110 equal or about equal to a reactant amount prediction 106. In some instances, the reactant amount predictions 106 can include an intermediate value, and can be further processed to determine a final amount of reactant 110 to be provided. For example, in some instances, a selective catalytic reduction system 112 may behave differently during a startup or shutdown process (e.g., last hour before shutdown, first hour after startup, etc.) compared to other times. In such instances, a reactant amount prediction 106 can include an intermediate value indicative of an optimal reactant flow for non-startup/shutdown conditions, and the reactant amount prediction 106 can be further processed to determine an amount of reactant 110 to be provided during the startup or shutdown process. For example, the reactant amount prediction 106 can be adjusted according to a reactant flow adjustment value associated with a startup or shutdown process, and the reactant amount prediction 106 can be modified based on the adjustment value (e.g., by adding, subtracting, multiplying, dividing, or performing another operation according to the adjustment value). In some instances, the reactant amount prediction 106 can be multiplied by a reactant flow multiplier associated with a startup or shutdown process, and an amount of reactant 110 equal to the product can be provided. However, this is not required. For example, in some instances, startup/shutdown status data can be provided as input data 102, and the machine learning system 104 can output a final reactant amount prediction 106 that accounts for the startup/shutdown status.

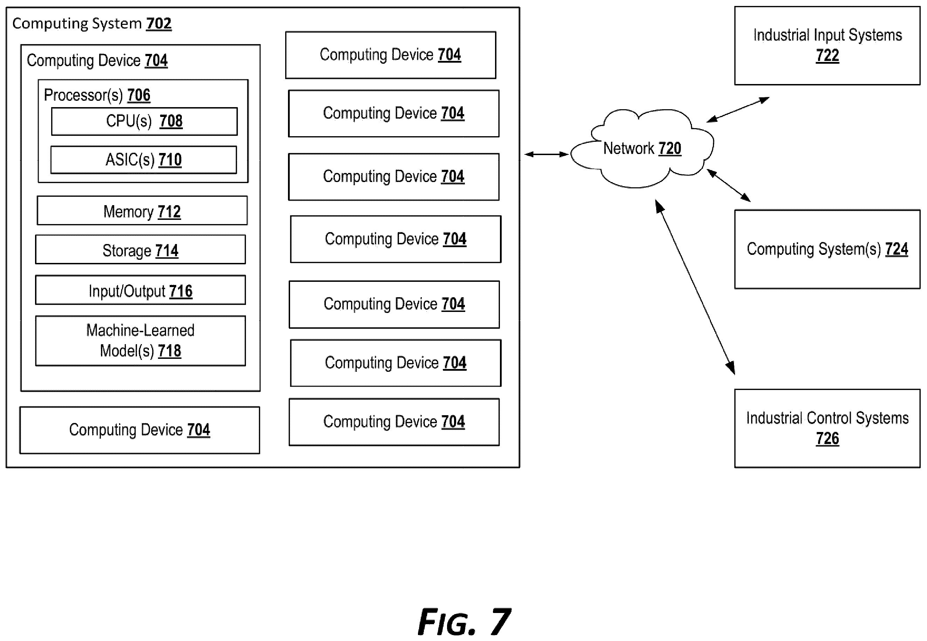

The reactant flow control system 108 can include, for example, any system for directly or indirectly controlling a fluid flow. As a non-limiting illustrative example, a reactant flow control system 108 could include one or more distributed control system (DCS) devices; one or more programmable logic controller (PLC) devices or human machine interface (HMI) devices; one or more supervisory control and data acquisition (SCADA) devices; proportional-integral-derivative (PID) control devices; or other control device. In some instances, the reactant flow control system 108 can include one or more computing devices or computing systems (e.g., as described below with respect to FIG. 7). In some instances, the reactant flow control system 108 can include one or more hardware devices (e.g., valves, actuators, etc.) for controlling a fluid flow. In some instances, the one or more hardware devices can be controlled by another component of the reactant flow control system (e.g., DCS device or other computing device, etc.). In some instances, reactant flow control system 108 can include a computing device (e.g., DCS device, PLC device, HMI device, etc.) configured to provide a signal (e.g., internal signal of the computing device, external signal, etc.) to cause an amount of reactant 110 (e.g., amount equal to a reactant amount prediction 106, etc.) to be provided to the selective catalytic reduction system 112. A signal can include, for example, an internal signal to a component of the computing device (e.g., from a processor to a hardware component of the computing device, etc.); an external signal to another device (e.g., hardware device such as valve, actuator, etc.; computing device such as DCS controller, PLC controller, etc.); or other signal. A signal can be provided via any appropriate connection, such as an internal connection of the computing device (e.g., bus, interconnect, transmission line, etc.) or external connection (e.g., network, wire, cable, port, input/output device, etc.).

Reactant 110 can include, for example, any reactant (e.g., reactant fluid) that can be provided to a selective catalytic reduction system 112. In some instances, a reactant 110 can include a fluid for converting nitrogen oxides ($NO_x$) into nitrogen ($N_2$) and water ($H_2O$). Example reactants for converting nitrogen oxides can include, for example, ammonia (e.g., anhydrous ammonia, aqueous ammonia, etc.), urea, a solution thereof (e.g., diesel exhaust fluid, etc.), or any appropriate reactant for processing emissions (e.g., $NO_x$ emissions, etc.).

A selective catalytic reduction system 112 can include, for example, any system for using a reactant 110 and a catalyst for reducing or converting one or more types of emissions (e.g., $NO_x$ emissions, etc.). In some instances, a selective catalytic reduction system 112 can include a catalyst bed or catalyst chamber. In some instances, the reactant 110 can be deposited on or in a catalyst bed or chamber, and a stream of flue or exhaust gas can pass through the bed or chamber and react with the reactant 110.

An industrial system 114 can include, for example, any system that may comprise or be associated with a selective catalytic reduction system 112. Example industrial systems can include, for example, any system that may include a combustion component (e.g., gas turbine, boiler, incinerator, internal combustion engines such as diesel engines, etc.).

Catalytically reduced emissions 116 can include, for example, any output (e.g., fluid such as gas) that has been processed by a selective catalytic reduction system 112 before being removed (e.g., emitted, exhausted, captured, etc.) from an industrial system 114. Example catalytically reduced emissions 116 can include, for example, a percentage of nitrogen ($N_2$) and water ($H_2O$), which may have been converted from other input gases (e.g., NO, $NO_2$, etc.).

An exhaust system 118 can include, for example, any system for releasing catalytically reduced emissions 116 from an industrial system 114 (e.g., exhaust stack of an industrial plant, vehicle exhaust system, etc.).

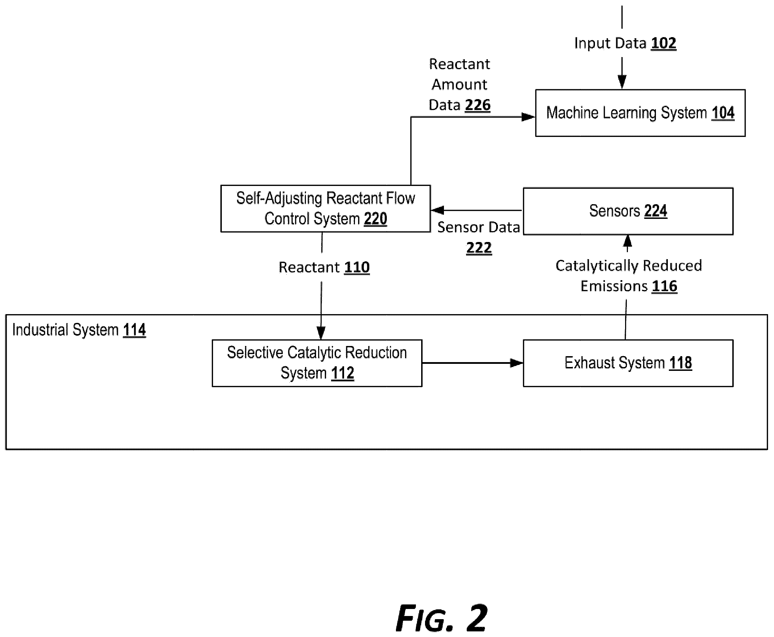

FIG. 2 is a block diagram of a system for training a machine learning system for controlling a selective catalytic reduction system in accordance with embodiments of the present disclosure. A self-adjusting reactant flow control system 220 can receive sensor data 222 from one or more sensors 224, and can adjust a flow of reactant 110 in response to the sensor data 222. When the self-adjusting reactant flow control system 220 converges on an optimal flow amount for a particular set of input conditions, reactant amount data 226 indicative of the optimal flow amount can be provided to a machine learning system 104 along with input data 102 indicative of the input conditions. The machine learning system 104 can then be trained based on the received data, such that the machine learning system 104 can learn to predict an optimal flow rate based on input data.

The self-adjusting flow control system 220 can include any system for adjusting a flow of reactant 110 in response to data including sensor data 222. In some instances, a self-adjusting flow control system 220 can be, comprise, or be comprised by a reactant flow control system 108. In some instances, a self-adjusting flow control system 220 can include a proportional-integral-derivative (PID) controller or similar controller for adjusting a flow of reactant 110 in response to sensor data 222. For example, a PID controller can be configured with one or more desired setpoints describing a target value (e.g., about 2 parts per million, about 5 parts per million, etc.) for one or more sensor data 222 variables (e.g., emissions data such as $NO_x$ emissions, ammonia slip, etc.), and can continually adjust a flow of reactant 1120 based on a difference between a current value of a sensor data 222 variable and the target value. For example, the PID controller can select an adjusted reactant flow value based on a formula such as:

$$adjustment(t) = K_1 error(t) + K_2 \int_{i=t-n}^{t} error(i)di + K_3 \frac{d(error(t))}{dt}$$

where *adjustment*(*t*) can be a change in an amount of flow of the reactant 110; $K_1$, $K_1$, and $K_1$ can be constants; and *error(t)* can be a difference between a target value (e.g., target setpoint) and actual value associated with a sensor data 222 variable at time t. In this manner, for instance, a PID controller can repeatedly adjust a flow rate of the reactant 110 until it converges on an optimal or preferred flow rate (e.g., when *error(t)* remains continually at zero for a period of time). In some instances, a PID controller or similar adjustment device can consider a plurality of variables (e.g., $NO_x$ data and ammonia slip data, etc.), and can select an adjustment amount based on a combination (e.g., sum, etc.) of two or more values (e.g., *adjustment*(*t*) values, etc.). However, a PID controller is not required. For example, any control system configured to converge (e.g., after an adjustment period, etc.) on an optimal or preferred amount of reactant 110 can be used. In some instances, a self-adjusting reactant flow control system 220 can include a machine-learned self-adjustment mechanism (e.g., comprising a machine learning system 104, 304 or other machine learning mechanism) to perform machine-learned adjustment of reactant 110 flow based on sensor data 222.

Sensor data 222 can include, for example, any data that may be relevant when adjusting an amount of reactant 110 to be provided to the selective catalytic reduction system. For example, in some instances, sensor data 222 can include emissions data (e.g., $NO_x$ emissions data, ammonia slip data, etc.), and a self-adjusting reactant flow control system 220 can adjust a flow of reactant 110 by comparing the emissions data to one or more emissions targets (e.g.,

goals, setpoints, etc.). In some instances, sensor data 222 can include other data, such as temperature data, pressure data, leakage sensor data, exhaust flow rate data, or other relevant sensor data 222. Sensor data 222 can include one type or many types of data. For example, in some instances, sensor data 222 can include numerical or binary data (e.g., floating-point numerical data, etc.) indicative of one or more numerical properties being sensed (e.g., emissions concentration in parts per million, etc.).

Sensors 224 can include, for example, any device or system configured to sense one or more aspects of an environment (e.g., $NO_x$ content, ammonia content, temperature, etc.) and provide sensor data 222 (e.g., emissions data, etc.) describing the one or more aspects. In some instances, the sensors 224 can include emissions sensors installed in or near an exhaust system 118 (e.g., near the top of an exhaust stack of an industrial plant, etc.).

Reactant amount data 226 can include data indicative of an amount of reactant 110 actually provided by the self-adjusting reactant flow control system 220 under the circumstances (e.g., after an adjustment period). For example, the self-adjusting reactant flow control system 220 can repeatedly adjust a flow rate of reactant 110 based on sensor data 222 (e.g., according to a PID formula, etc.) until converging on a steady-state flow rate of reactant 110 (e.g., according to one or more emissions setpoints, etc.). In some instances, a steady-state flow rate can include a flow rate that has not changed (e.g., at all) for a particular period of time (e.g., several seconds, etc.). In some instances, a steady-state flow rate can include a flow rate that has not changed very much for a particular period of time (e.g., a predefined time window, dynamically determined time window, etc.). For example, in some instances, a change threshold can be defined, and a flow rate can be determined to be at a steady state if a change (e.g., net change, maximum peak-to-trough distance, etc.) in flow rate over a particular period of time is less than the threshold. After arriving at a steady-state flow rate, the self-adjusting reactant flow control system 220 can provide reactant amount data 226 indicative of the steady-state flow rate to the machine learning system 104 for training or other learning. In this manner, for instance, the machine learning system 104 can learn the true steady-state values selected by the self-adjusting flow control system 220, which may in some instances correspond to optimal or preferred flow rates based on sensor data 222. Reactant amount data can include one type or many types of data. In some instances, reactant amount data 226 can include numerical (e.g., floating-point, etc.) or binary data indicative of a numerical flow rate of reactant 110.

Based on the reactant amount data 226, the machine learning system 104 can be trained to generate reactant amount predictions 106 that are predictive of future reactant amount data 226. Training a machine learning system 104 based on reactant amount data 226 can include any process that uses the reactant amount data 226 to modify one or more future reactant amount predictions 106. For example, in some instances, training a parametrized machine-learning system 104 (e.g., neural network, etc.) can include any process for updating one or more parameters of the parametrized machine-learning system 104 based on the reactant amount data 226. As another example, training a retrieval-based machine-learning system 104 (e.g., neighbor-based retrieval system, etc.) can include storing the reactant amount data 226 in a data structure from which the retrieval-based machine-learning system 104 retrieves data at inference time. For example, training the machine learning system 104 can include correlating reactant amount data 226 with corresponding input data 102 describing one or more circumstances (e.g., turbine load, ambient conditions, flue gas temperature, duct burner fuel flow, emissions sensor data, startup or shutdown status, etc.) in which the reactant amount data 226 was generated. Training the machine learning system 104 can further include storing the correlated data in a data structure that the machine learning system 104 will use at inference time to generate reactant amount predictions 106. In this manner, for instance, the reactant amount data 226 can be used to modify one or more future reactant amount predictions 106, thereby training the machine learning system 104. Additional details of an example method for training an example machine learning system 104 based on reactant amount data 226 are further provided below with respect to FIG. 3.

FIG. 3 is a block diagram of an example machine learning system for controlling a selective catalytic reduction system in accordance with embodiments of the present disclosure. The machine learning system 304 can receive input data 102, and can retrieve one or more stored data examples 328 based on the input data 102. For example, in some instances, a nearest neighbor retrieval 330 system can retrieve stored data examples 328 that are associated with operating conditions similar to one or more operating conditions associated with the input data 102. Based on the retrieved neighbor data 332, the machine learning system 304 can perform neighborhood-based inference 334 to determine a reactant amount prediction 106. In some instances, the reactant amount prediction 106 can be provided to a reactant flow control system 108 as depicted in FIG. 1. In some instances, the machine-learned model 304 can be trained based on reactant amount data 226 as depicted in FIG. 2. For example, the machine-learned model 304 can be provided with reactant amount data 226 as depicted in FIG. 2, and can compare the reactant amount data 226 to the reactant amount prediction 106 using a comparison system 338. Based on the comparison, the machine learning system 304 can determine whether to add the reactant amount data 226 to the stored data examples 328. For example, if the reactant amount data 226 is "surprising" to the machine learning system 304 (e.g., different from the reactant amount prediction 106 expected by the machine learning system 304), then a surprising example 340 can be added to the stored data examples 328. Additionally, in some instances, the machine-learning system can perform selective forgetting, wherein one or more stored data examples 328 can be deleted under various circumstances (e.g., in response to a surprising example 340 being added, etc.).

In some instances, a machine learning system 304 can be, comprise, be comprised by, or otherwise share one or more properties with a machine learning system 104. In some instances, the machine learning system 304 can comprise some or all of the components depicted in FIG. 3. However, FIG. 3 depicts one example arrangement of a machine learning system 304, and other configurations can be used as well. For example, individual components depicted can be omitted, rearranged, or added without deviating from the scope of the present disclosure.

The stored data examples 328 can include one or more data structures (e.g., databases; data collections such as arrays, lists, stacks, etc.; data objects; files, folders, or other file-based data structures; etc.) comprising a plurality of data examples. Each stored data example 328 can include, for example, data correlating one or more input values (e.g., input data 102, etc.) with data indicative of a reactant amount (e.g., optimal or steady-state reactant amount; reactant amount data 226; etc.). The stored data examples 328 can include one type or many types of data, such as numerical data (e.g., integer, floating-point, quantized numerical data, etc.), binary data, raw sensor data, or any other data format.

In some instances, a data structure for storing the stored data examples 328 can include a fixed-size or variable-size data structure for storing a fixed or variable number of data examples. For example, a data structure correlating one input variable with a reactant amount can in some instances include a small, fixed number (e.g., 8, 16, 32, 48, 64, etc.) of data examples. As another example, a data structure correlating a plurality of $n$ input variables may have a larger, fixed number of data examples, which may scale with $n$ (e.g., $16n, 32n,$ $16 * 2^n$, $8*4^n$, etc.).

In some instances, a fixed-size data structure can be used in combination with a selective forgetting process. For example, in some instances, a data structure can have a fixed maximum number of data examples. When a surprising example 340 is identified, a computing system can determine whether the number of stored data examples 328 is already equal to the maximum number. If it is, then the computing system can remove a prior stored data example 328 before adding the new surprising example 340. In some instances, a choice of which stored data example 328 to delete can depend on one or more of: an age of each stored data example 328; a proximity or similarity of the stored data examples 328 to the surprising example 340 (e.g., according to a measure of vector distance, etc.); whether or not each stored data example 328 was part of the retrieved neighbor data 332; or other appropriate factor. For example, a stored data example 328 selected for deletion can include: an oldest overall stored data example 328 (e.g., throughout the entire stored data examples 328 data structure); an oldest retrieved neighbor 332; a nearest retrieved neighbor 332; or other appropriate stored data example 328.

In some instances, a size of a fixed-size data structure can be selected to optimize a performance of the machine learning system 304 in combination with a selective forgetting process. In some instances, an optimal data structure size for the stored data examples 328 may depend on the complexity of the relationship between the input variable and reactant amount; a measurement range of the input variable; or other relevant factor. In some instances, an appropriate scaling of the data structure size can depend on a level of correlation or independence between the n input variables.

In some instances, a variable-size data structure can be used in combination with a selective forgetting process. A determination of whether to remove a stored data example 328 can depend, for example, on an age of each stored data example 328; a proximity of each stored data example 328 to a newly added surprising example 340; or other appropriate factor.

In some instances, a stored data example 328 can be removed based on a similarity to its immediate neighbors. For example, if a stored data example 328 comprises reactant amount data 226 that can be accurately predicted by a machine learning system 304 without retaining the stored data example 328, then the stored data example 328 can be deleted (e.g., from a fixed-size data structure; from a variable-sized data structure; etc.). As an illustrative example, if a neighborhood-based inference 334 (e.g., as further described below) operates by performing linear interpolation between nearby datapoints, then a stored data example 328 can be safely deleted if it is sufficiently close to a line interpolating between two nearby stored data examples 328. In some instances, determining whether to delete a stored data example 328 can include determining a reactant amount prediction 106 associated with input data 102 of the stored data example 328; comparing the reactant amount prediction 106 to reactant amount data 226 of the stored data example 328; and determining, based on the comparison, whether to delete the stored data example 328. In some instances, comparing the reactant amounts 106, 226 can include determining an absolute value of a difference between the reactant amounts 106, 226. In some instances, determining whether to delete the stored data example 328 can include comparing the absolute value of the difference to a difference threshold, and deleting the stored data example 328 if the difference is less than the difference threshold. In some instances, if two or more stored data examples 328 could be safely deleted in this manner, an oldest data example of the two or more stored data examples 328 can be deleted first.

A nearest neighbor retrieval 330 can include any retrieval of one or more (e.g., plurality of) stored data examples 328 based on input data 102. In some instances, a nearest neighbor retrieval 330 can include a retrieval of a plurality of stored data examples 328 based on a similarity between the input data 102 and one or more corresponding data fields of the stored data examples 328. As a simplified illustrative example, the input data 102 may include data indicative of a turbine load, and the stored data examples 328 can include data correlating turbine load to a reactant amount. In such an example, a nearest neighbor retrieval 330 can retrieve stored data examples 328 associated with turbine loads that are similar to (e.g., numerically close to, etc.) the turbine load of the input data 102. In some instances, a nearest neighbor retrieval 330 can retrieve one or more closest neighbors in each direction of two or more directions (e.g., the closest neighbor with higher turbine load and the closest neighbor with lower turbine load, etc.). In some instances, a nearest neighbor retrieval 330 can retrieve close neighbors without regard to direction (e.g., two closest neighbors, k nearest neighbors, etc.).

In some instances, input data 102 may contain a plurality of input variables (e.g., turbine load, flue gas temperature, duct burner fuel flow, ambient conditions, emissions sensor data, startup or shutdown status data, etc.), and the nearest neighbor retrieval 330 may determine similarity based on some combination of the plurality of input variables. For example, in some instances, the input data 102 can include a plurality of numerical input variables or input variables that can be converted to a numerical value (e.g., Boolean variables, etc.). In such instances, the input data 102 can be treated as a vector, and the nearest neighbor retrieval 330 can be based on a vector-based distance metric (e.g., cosine distance, Euclidean distance, Manhattan distance, etc.) between the input data 102 and each stored data example 328.

In some instances, one or more input variables of the input data 102 can be normalized (e.g., to a common scale, such as a scale from zero to one, etc.) before computing a distance metric. In some instances, normalization can include identifying a minimum and maximum value for each input variable of the input data 102, and rescaling the variable so that the minimum value corresponds to a common minimum value (e.g., zero) and the maximum value corresponds to a common maximum value (e.g., one) that may be common to all input variables of the input data 102. As an illustrative example, a temperature range may include a minimum temperature of 550 degrees Fahrenheit, and a maximum temperature of 700 degrees Fahrenheit. In such instances, normalizing the temperature range to a scale from zero to one can include subtracting 550 degrees (the identified minimum, minus zero) from a temperature value of the input data 102, then dividing by 150 (the difference between maximum and minimum, divided by one). A minimum and maximum can include a true minimum or maximum (e.g., theoretically defined or physically defined minimum or maximum, such as zero percent, 100 percent, zero Kelvin, etc.) or a value selected for use as a minimum or maximum (e.g., value corresponding to a likely practical minimum or maximum, etc.). In instances where a minimum or maximum value is not a true minimum or maximum, input data 102 having values below a minimum or above a maximum can be treated as being equal to the minimum or maximum for the purposes of normalization.

Retrieved neighbor data 332 can include one or more (e.g., a plurality of) stored data examples 328 retrieved by the nearest neighbor retrieval 330. In some instances, a number of stored data examples 328 retrieved can be a predetermined or fixed number (e.g., k nearest neighbors). In some instances, a number of stored data examples 328 to retrieve can be determined dynamically. For example, in some instances, a number of stored data examples 328 retrieved can be determined based on a similarity threshold (e.g., vector distance threshold, etc.). In some instances, each stored data example 328 having a similarity exceeding a similarity threshold (e.g., vector distance below a vector distance threshold, etc.) can be retrieved. Other methods are possible.

Neighborhood-based inference 334 can include any method for combining retrieved neighbor data 332 to generate a reactant amount prediction 106. For example, various statistical methods or machine learning methods can be used to combine data examples to generate a prediction, such as parametric, nonparametric, or semiparametric regression; linear, polynomial, or other interpolation; etc. As a simplified illustrative example, a machine-learning system 304 generating reactant amount predictions 106 based on one input variable could receive an input value; retrieve two stored data examples 328 associated with similar input values; and perform linear interpolation between the two stored data examples 328 to generate a reactant amount prediction 106. As another example, a machine-learning system 304 predicting optimal flow based on two or more input variables could receive input data 102; retrieve a plurality of stored data examples 328 (e.g., at least one more than the number of input variables, etc.) associated with similar input values; and perform linear regression based on the plurality of stored data examples 328 to generate a reactant amount prediction 106. Other methods for combining retrieved neighbor data 332 to generate a reactant amount prediction 106 are possible (e.g., averaging, weighted averaging such as distance-weighted averaging, nonlinear methods, etc.).

A comparison system 338 can include any system for comparing a reactant amount prediction 106 to reactant amount data 226 and determining, based on the comparison, whether to store a new stored data example 328. In some instances, the comparison can include determining a measure of similarity between the reactant amount prediction 106 and the reactant amount data 226 (e.g., absolute value of the difference between the two reactant amounts 106, 226; etc.). In some instances, determining whether to store the data can include comparing a difference between the two reactant amounts 106, 226 to a difference threshold, and storing a surprising example 340 if an absolute value of the difference is greater than the difference threshold. Other methods are possible.

A surprising example 340 can include, for example, any data example that a comparison system 338 selects for storage. A surprising example 340 can be, comprise, be comprised by, or otherwise share one or more properties with a stored data example 328.

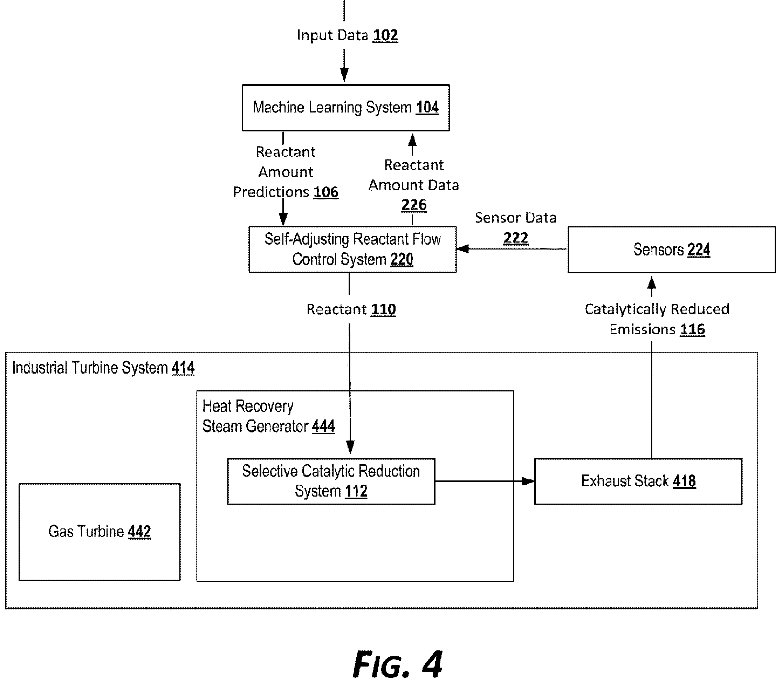

FIG. 4 is a block diagram of a system for controlling a selective catalytic reduction system using machine learning, while continuously training the machine learning control system during operation in accordance with embodiments of the present disclosure. A machine learning system 104 can provide reactant amount predictions 106 to a self-adjusting reactant flow control system 220, which can provide an amount of reactant 110 to a selective catalytic reduction system 112 based on the reactant amount predictions 106 (e.g., as depicted in FIG. 1). Sensors 224 can then provide sensor data 222 to the self-adjusting reactant flow control system 220, which can adjust a flow rate of the reactant 110 based on the sensor data 222. After converging on a steady-state flow rate, the self-adjusting flow control system 220 can provide reactant amount data 226 to the machine learning system 104 (e.g., in a manner depicted in FIG. 2, etc.). The machine learning system 104 can then be trained based on the new reactant amount data 226 (e.g., in a manner depicted in FIG. 3, etc.). In this manner, for instance, the machine learning system 104 can continuously learn during operation of an industrial system, even while outputs of the machine learning system 104 are being used to control a flow of reactant 110.

In some instances, an amount of reactant 110 provided to the selective catalytic reduction system 112 can be held steady throughout a latency period before the self-adjusting reactant flow control system 220 begins adjusting the amount of reactant 110 (e.g., based on sensor data 222, etc.). For example, in some instances, an operating change in an industrial system 114 (e.g., industrial turbine system 414) may cause a time-delayed change in sensor data 222 (e.g., $NO_x$ emissions data, etc.). For example, a change in an operating variable (e.g., turbine load, flue gas temperature, duct burner fuel flow, ambient conditions, startup or shutdown status, etc.) may cause a time-delayed change in emissions at the top of an exhaust stack 418. In some instances, this time-delayed change may not occur until several minutes (e.g., four minutes, etc.) after the operating variable is changed. In such instances, an amount of reactant 110 based on a reactant amount prediction 106 can be provided for the first several minutes after a change in an operating variable, and the amount of reactant 110 can then be automatically adjusted by the self-adjusting reactant flow control system 220 (e.g., based on sensor data 222) after the latency period is over (e.g., after enough time has passed for an effect of the operating variable change to be seen in the sensor data 222, etc.). After the latency period is over, the self-adjusting reactant flow control system 220 can continue adjusting the flow of reactant 110 until convergence on a steady-state flow rate (e.g., as described with respect to FIG. 2), or until another operating change is made, thereby triggering another latency period in which an amount of reactant 110 can be held steady according to a new reactant amount prediction 106.

As depicted in FIG. 4, the selective catalytic reduction system 112 can be a component of an industrial turbine system 414 comprising a gas turbine 442, heat recovery steam generator 444, exhaust stack 418, etc. However, other industrial systems 114 are possible. An industrial turbine system 414 can be, comprise, or be comprised by an industrial system 114. An exhaust stack 418 (e.g., smokestack, emissions stack, etc.) can be, comprise, or be comprised by an exhaust system 118.

A gas turbine 442 and heat recovery steam generator 444 can include any kind of turbine system or steam generation system. For example, a gas turbine 442 can include a compressor section, a combustion section, a turbine section, and an exhaust section. The compressor section progressively increases the pressure of a working fluid entering the gas turbine engine and supplies this compressed working fluid to the combustion section. The compressed working fluid and a fuel (e.g., natural gas) mix within the combustion section and burn in a combustion chamber to generate high pressure and high temperature combustion gases. The combustion gases flow from the combustion section into the turbine section where they expand to produce work. For example, expansion of the combustion gases in the turbine section may rotate a rotor shaft connected, e.g., to a generator to produce electricity. The combustion gases then exit the gas turbine via the exhaust section. A heat recovery steam generator 444 can include, for example, any system for generating steam from a heat source (e.g., exhaust from a gas turbine 442, etc.). In some instances, a heat recovery steam generator 444 can include a selective catalytic reduction system 112 (e.g., at a location selected to optimize a temperature at which a catalytic reaction occurs, etc.).

Example Methods

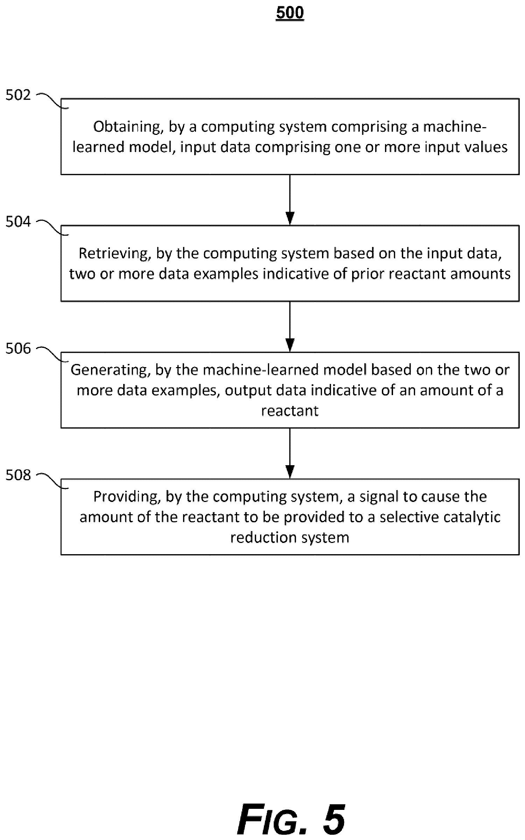

FIG. 5 depicts a flowchart diagram of an example method for controlling a selective catalytic reduction using machine learning according to example embodiments of the present disclosure. Although FIG. 5 depicts steps performed in a particular order for purposes of illustration and discussion, the methods of the present disclosure are not limited to the particularly illustrated order or arrangement. The various steps of example method 500 can be omitted, rearranged, combined, and/or adapted in various ways without deviating from the scope of the present disclosure.

At 502, example method 500 can include obtaining, by a computing system comprising a machine-learned model, input data (e.g., input data 102) comprising one or more input values. In some instances, example method 500 at 502 can include using one or more systems or performing one or more activities described with respect to FIGS. 1, 3, or 4.

At 504, example method 500 can include retrieving, by the computing system based on the input data, two or more data examples (e.g., stored data examples 328, retrieved neighbor data 332, etc.) indicative of prior reactant amounts (e.g., reactant amount data 226, etc.). In some instances, example method 500 at 504 can include using one or more systems or performing one or more activities described with respect to FIGS. 1, 3, or 4.

At 506, example method 500 can include generating, by the machine-learned model based on the two or more data examples, output data (e.g., reactant amount prediction 106, etc.) indicative of an amount of a reactant (e.g., reactant 110, etc.). In some instances, example method 500 at 506 can include using one or more systems or performing one or more activities described with respect to FIGS. 1, 3, or 4.

At 508, example method 500 can include providing, by the computing system, a signal to cause the amount of the reactant to be provided to a selective catalytic reduction system (e.g., selective catalytic reduction system 112). In some instances, example method 500 at 508 can include using one or more systems or performing one or more activities described with respect to FIGS. 1, 3, or 4.

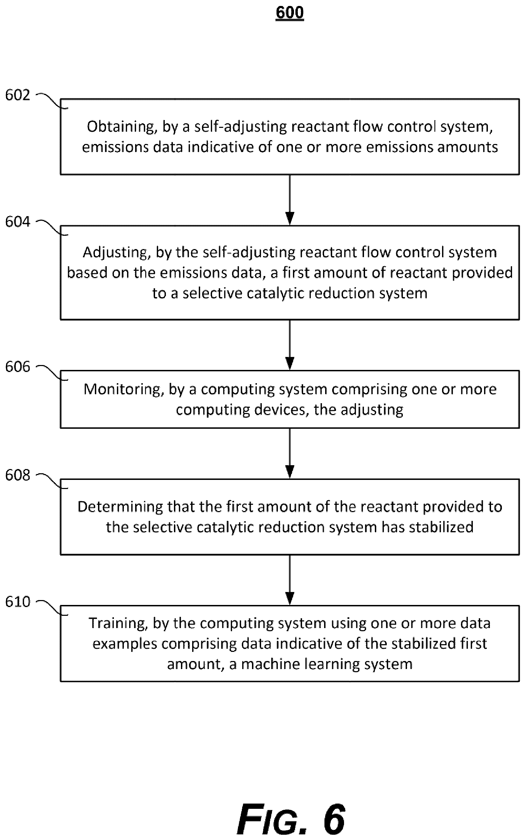

FIG. 6 depicts a flowchart diagram of an example method for training a machine learning system (e.g., 104, 304, etc.) according to example embodiments of the present disclosure. Although FIG. 6 depicts steps performed in a particular order for purposes of illustration and discussion, the methods of the present disclosure are not limited to the particularly illustrated order or arrangement. The various steps of example method 600 can be omitted, rearranged, combined, and/or adapted in various ways without deviating from the scope of the present disclosure.

At 602, example method 600 can include obtaining, by a self-adjusting reactant flow control system, emissions data indicative of one or more emissions amounts. In some instances, example method 600 at 602 can include using one or more systems or performing one or more activities described with respect to FIGS. 2 or 4.

At 604, example method 600 can include adjusting, by the self-adjusting reactant flow control system based on the emissions data, a first amount of reactant provided to a selective catalytic reduction system. In some instances, example method 600 at 604 can include using one or more systems or performing one or more activities described with respect to FIGS. 2 or 4.

At 606, example method 600 can include monitoring, by a computing system comprising one or more computing devices (e.g., computing system 702, etc.), the adjusting. In some instances, example method 600 at 606 can include using one or more systems or performing one or more activities described with respect to FIGS. 2 or 4.

At 608, example method 600 can include determining that the first amount of the reactant provided to the selective catalytic reduction system has stabilized. In some instances, example method 600 at 608 can include using one or more systems or performing one or more activities described with respect to FIGS. 2 or 4.

At 610, example method 600 can include training, by the computing system using one or more data examples (e.g., stored data examples 328) comprising data indicative of the stabilized first amount (e.g., reactant amount data 226), a machine learning system (e.g., machine learning system 104, 304). In some instances, example method 600 at 610 can include using one or more systems or performing one or more activities described with respect to FIGS. 2, 3, or 4.

Example Computing Systems and Devices

FIG. 7 is a block diagram of an example computing system. Computing system 702 can include one or more computing devices 704, which can each include processor devices 706, memory devices 712, storage devices 714, or input/output devices 716. A computing device 704 can include one or more machine-learned models 718 (e.g., machine learning system 104, machine learning system 304) or portions thereof, which can be located, for example, in a storage device 714 or memory device 712. The computing system 702 can be connected via a network 720 to one or more other systems, such as one or more industrial input systems 722 (e.g., systems for obtaining or providing input data 102, sensors 224 for providing sensor data 222 inputs, etc.), computing systems 724 (e.g., client computing systems, third-party computing systems, computing systems for controlling or monitoring an industrial process, etc.), or industrial control systems 726 (e.g., reactant flow control systems 108, etc.).

Computing system 702 can include any number of computing devices 704, such as one computing device 704 or many computing devices 704. A computing device 704 can include any type of computing device, such as a DCS controller, PLC controller, PID controller, server, workstation, desktop, laptop, virtual machine, mobile device, or other computing device.

Processors 706 can include, for example, one or more central processing units (CPUs) 708 and one or more application-specific integrated circuits (ASICs) 710, such as ASICs for performing floating-point operations (e.g., GPUs, etc.), ASICs for performing matrix multiplication, ASICs for performing machine-learning or artificial intelligence tasks, or other ASICs. The CPUs 708 can comprise, for example, any hardware configured to operate as a CPU (e.g. a microprocessor, microcontroller, soft-core processor, etc.).

Memory devices 712 can include, for example, one or more non-transitory computer-readable storage media for temporary storage of data (e.g., to facilitate faster data access relative to storage devices 714). Temporary storage media can include, for example, one or more memory devices such as high-bandwidth memory, random access memory (e.g., RAM, DRAM, SDRAM, DDR SRAM, etc.), virtual memory, cache memory, etc. Memory devices 712 can include, for example, volatile memory, non-volatile memory, and semi-volatile memory.

Storage devices 714 can include, for example, one or more non-transitory computer-readable storage media for persistent storage of data (e.g., including when a computing device 704 is powered down). Persistent storage devices can include non-volatile storage devices such as read-only memory (e.g., ROM, PROM, EPROM, EEPROM, etc.), flash memory (e.g., NAND flash memory, etc.), magnetic storage devices (e.g., hard disk drives, floppy disks, etc.), optical storage devices (e.g., CD, DVD, Blu-Ray, etc.), or other non-volatile memory. In some instances, storage devices 714 can include volatile or semi-volatile memory coupled with a continuous power source (e.g., electrical grid power source, backup battery, etc.) provided to the semi-volatile memory to preserve data when a computing device 704 is shut down.

Input/output devices 716 can include, for example, any device or component for receiving input from or providing output to a device, system, person, or other entity other than the computing device 704. Input/output devices 716 can include, for example, network connections; network cards or network adapters for communicating over a network connection; human input/output devices such as keyboards, mouses, display monitors, speakers, cameras, microphones, etc.; or other input/output devices. In some instances, input/output devices 716 can include one or more sensors, such as sensors 224 associated with an industrial system 114. In some instances, input/output devices 716 can include one or more devices for communicating with such sensors.

Machine-learned models 718 can include, for example, data storing one or more parameters of a machine-learned model or stored data examples 328 of a retrieval-based machine learning system 304; computer-readable instructions (e.g., source code, object code, etc.) that, when executed by one or more processors 706, will cause the processors to perform one or more operations of the machine-learned model; or any other data or components associated with a machine-learned model (e.g., machine learning system 104, etc.).

The network 720, can be or comprise, for example, the Internet or any other network (e.g., local area network, wide area network, peer-to-peer network, etc.) configured to transfer computer-readable data between computing devices. The network 720 can include, for example, wired connections, wireless connections, or a combination of both wired and wireless connections. In some instances, the network 720 can be associated with one or more communication protocols for communicating over the network 720, such as transmission control protocol (TCP), internet protocol (IP), hypertext transfer protocol (HTTP), user datagram protocol (UDP), border gateway protocol (BGP), address resolution protocol (ARP). In some instances, the network 720 can be associated with one or more security protocols for secure communication over the network 720, such as a secure socket layer (SSL) or transport layer security (TLS) protocol.

Industrial input systems 722 can include any type of computing device, such as a workstation, server, laptop, desktop, mobile device, virtual device, or other computing system. Industrial input systems 722 can include, for example, client computing systems, server computing systems, or third-party computing systems. In some instances, an industrial input system 722 can include any component or have any property described above with respect to computing device 704. In some instances, an industrial input system 722 can include one computing device or a plurality of computing devices.

Computing systems 724 can include any type of computing device, such as a workstation, server, laptop, desktop, mobile device, virtual device, or other computing system. Computing systems 724 can include, for example, client computing systems, server computing systems, or third-party computing systems. In some instances, a computing system 724 can include any component or have any property described above with respect to computing device 704. In some instances, a computing system 724 can include one computing device or a plurality of computing devices.

Industrial control systems 726 can include any type of computing device, such as a PLC controller, DSC controller, PID controller, workstation, server, laptop, desktop, mobile device, virtual device, or other computing system. Industrial control systems 726 can include, for example, client computing systems, server computing systems, or third-party computing systems. **In** some instances, an industrial control system 726 can include any component or have any property described above with respect to computing device 704. **In** some instances, an industrial control system 726 can include one computing device or a plurality of computing devices.

FIG. 7 illustrates one example arrangement of computing systems that can be used to implement the present disclosure. Other computing system configurations can be used as well. For example, individual components depicted can be omitted, rearranged, or added without deviating from the scope of the present disclosure.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal language of the claims.

Further aspects of the invention are provided by the subject matter of the following clauses:

A method for selective catalytic reduction, comprising: obtaining, by a computing system comprising a machine-learned model, input data comprising one or more input values; generating, by the machine-learned model based on the input data, output data indicative of an amount of a reactant; and providing, by the computing system, a signal to cause the amount of the reactant to be provided to a selective catalytic reduction system.

The method of one or more of these clauses, wherein generating the output data comprises: retrieving, by the computing system from a data structure, two or more data examples indicative of prior reactant amounts; and generating, by the machine-learned model based on the two or more data examples, the output data.

The method of one or more of these clauses, wherein the two or more data examples are retrieved based on a metric of similarity between the input data and each of the two or more data examples.

The method of one or more of these clauses, wherein generating the output data based on the two or more data examples comprises at least one of: interpolation; and regression.

The method of one or more of these clauses, wherein generating the output data based on the two or more data examples comprises at least one of: linear interpolation; and linear regression.

The method of one or more of these clauses, wherein the input data comprises data indicative of a turbine load.

The method of one or more of these clauses, wherein the output data indicative of the amount comprises a first reactant amount value, and further comprising: determining, by the computing system based on a startup or shutdown process of an industrial system comprising the selective catalytic reduction system, a reactant amount adjustment value; adjusting, by the computing system based on the reactant amount adjustment value, the first reactant amount value to generate the amount of the reactant.

The method of one or more of these clauses, further comprising: providing, by the computing system, one or more signals to cause the amount of the reactant to be provided to a selective catalytic reduction system throughout a first time period associated with a latency of emissions data associated with the selective catalytic reduction system; and adjusting, by a self-adjusting reactant flow control system after the first time period, a reactant flow provided to the selective catalytic reduction system.

The method of one or more of these clauses, wherein the self-adjusting reactant flow control system comprises a proportional-integral-derivative controller.

The method of one or more of these clauses, further comprising: determining, by the computing system based on the adjusting, an adjusted reactant amount; and storing, by the computing system, data indicative of the adjusted reactant amount in a training data structure associated with the machine-learned model.

The method of one or more of these clauses, further comprising: determining, by the computing system based on a comparison between the adjusted reactant amount and the amount of the reactant, whether to store the data indicative of the adjusted reactant amount in the training data structure associated with the machine-learned model; and wherein the storing is performed responsive to determining that the data should be stored.

The method of one or more of these clauses, wherein determining the adjusted reactant amount comprises: monitoring, by the computing system, the adjusting; determining that the reactant flow has stabilized; and determining, by the computing system based on the stabilized reactant flow, the adjusted reactant amount.

A method for training a machine-learned model for outputting a reactant amount, comprising: obtaining, by a self-adjusting reactant flow control system, emissions data indicative of one or more emissions amounts; adjusting, by the self-adjusting reactant flow control system based on the emissions data, a first amount of reactant provided to a selective catalytic reduction system; monitoring, by a computing system comprising one or more computing devices, the adjusting; determining that the first amount of the reactant provided to the selective catalytic reduction system has stabilized; and training, by the computing system using one or more data examples comprising data indicative of the stabilized first amount, the machine-learned model.

The method of one or more of these clauses, wherein the machine-learned model is configured to: retrieve, responsive to receiving one or more inference inputs, data from a data structure comprising the one or more data examples based on the one or more inference inputs; and generate, based on the retrieved data, an output.

The method of one or more of these clauses, further comprising: providing, by the computing system to the machine-learned model, input data associated with a system state of an industrial system comprising the selective catalytic reduction system; generating, by the machine-learned model based on the input data, output data indicative of a second amount of the reactant; determining, based on a comparison between the first amount and the second amount, whether to store the data indicative of the first amount in a data structure comprising the one or more data examples.

The method of one or more of these clauses, further comprising: deleting, by the computing system from a data structure comprising the one or more data examples, an earlier data example comprising data indicative of an earlier reactant amount.

The method of one or more of these clauses, further comprising: determining whether an industrial system comprising the self-adjusting reactant flow control system is in one or more predetermined conditions indicative of a lack of emissions data quality; and responsive to determining that the industrial system is not in any of the one or more predetermined conditions, training the machine-learned model using the one or more data examples.

The method of one or more of these clauses, wherein the one or more predetermined conditions comprise at least one of: a startup process of the industrial system; a shutdown process of the industrial system; a calibration mode of a component of the industrial system; and a data signal having a current or voltage outside an expected current range or voltage range.

The method of one or more of these clauses, wherein the self-adjusting reactant flow control system comprises a proportional-integral-derivative controller.

A computing system comprising: one or more processors; and one or more non-transitory computer-readable media that collectively store: a machine-learned model; and instructions that, when executed by the one or more processors, cause the computing system to perform operations, the operations comprising: the method of one or more of these clauses.

**Claims**

1. A method for selective catalytic reduction, comprising:

    obtaining, by a computing system (702) comprising a machine-learned model (718), input data (102) comprising one or more input values;
    generating, by the machine-learned model (718) based on the input data (102), output data indicative of an amount (106) of a reactant (110); and
    providing a signal, by the computing system (702), to cause the amount (106) of the reactant (110) to be provided to a selective catalytic reduction system (112).

2. The method of claim 1, wherein generating the output data comprises:

    retrieving, by the computing system (702) from a data structure, two or more data examples (328) indicative of prior reactant amounts; and
    generating, by the machine-learned model (718) based on the two or more data examples (328), the output data.

3. The method of claim 2, wherein the two or more data examples (328) are retrieved based on a metric of similarity between the input data (102) and each of the two or more data examples (328); and/or
    wherein generating the output data based on the two or more data examples (328) comprises at least one of:

    interpolation, preferably linear interpolation; and
    regression, preferably linear regression.

4. The method of anyone of the preceding claims, wherein the input data (102) comprises data indicative of a turbine load.

5. The method of anyone of the preceding claims, wherein the output data indicative of the amount (106) comprises a first reactant amount value, and further comprising:

    determining, by the computing system (702) based on a startup or shutdown process of an industrial system (114) comprising the selective catalytic reduction system (112), a reactant amount adjustment value;
    adjusting, by the computing system (702) based on the reactant amount adjustment value, the first reactant amount value to generate the amount (106) of the reactant (110).

6. The method of anyone of the preceding claims, further comprising:

    providing, by the computing system (702), one or more signals to cause the amount (106) of the reactant (110) to be provided to the selective catalytic reduction system (112) throughout a first time period associated with a latency of emissions data associated with the selective catalytic reduction system (112);
    adjusting, by a self-adjusting reactant flow control system (220) after the first time period, a reactant flow provided to the selective catalytic reduction system (112).

7. The method of claim 6, further comprising:

    determining, by the computing system (702) based on the adjusting, an adjusted reactant amount; and
    storing, by the computing system (702), data indicative of the adjusted reactant amount in a training data structure associated with the machine-learned model (718).

8. The method of claim 7, further comprising:

    determining, by the computing system based on a comparison between the adjusted reactant amount and the amount (106) of the reactant (110), whether to store the data indicative of the adjusted reactant amount in the training data structure associated with the machine-learned model (718); and
    wherein the storing is performed responsive to determining that the data should be stored.

9. The method of claim 7 or 8, wherein determining the adjusted reactant amount comprises:

monitoring, by the computing system (702), the adjusting;
determining that the reactant flow has stabilized; and
determining, by the computing system (702) based on the stabilized reactant flow, the adjusted reactant amount.

10. A method for training a machine-learned model (718) for outputting a reactant amount (106), comprising:

obtaining, by a self-adjusting reactant flow control system (220), emissions data indicative of one or more emissions amounts;
adjusting, by the self-adjusting reactant flow control system (220) based on the emissions data, a first amount of reactant provided to a selective catalytic reduction system (112);
monitoring, by a computing system (702) comprising one or more computing devices (704), the adjusting;
determining that the first amount of the reactant provided to the selective catalytic reduction system (112) has stabilized; and
training, by the computing system (702) using one or more data examples (328) comprising data indicative of the stabilized first amount, the machine-learned model (718).

11. The method of claim 10, wherein the machine-learned model (718) is configured to:

retrieve, responsive to receiving one or more inference inputs, data from a data structure comprising the one or more data examples (328) based on the one or more inference inputs; and
generate, based on the retrieved data (332), an output.

12. The method of claim 10 or 11, further comprising:

providing, by the computing system (702) to the machine-learned model (718), input data (102) associated with a system state of an industrial system (114) comprising the selective catalytic reduction system (112);
generating, by the machine-learned model (718) based on the input data (102), output data indicative of a second amount of the reactant;
determining, based on a comparison between the first amount and the second amount, whether to store the data indicative of the first amount in a data structure comprising the one or more data examples (328).

13. The method of anyone of the claims 10-12, further comprising:
deleting, by the computing system (702) from a data structure comprising the one or more data examples (328), an earlier data example comprising data indicative of an earlier reactant amount.

14. The method of anyone of the claims 11-13, further comprising:

determining whether an industrial system (114) comprising the self-adjusting reactant flow control system (220) is in one or more predetermined conditions indicative of a lack of emissions data quality; and
responsive to determining that the industrial system (114) is not in any of the one or more predetermined conditions, training the machine-learned model (718) using the one or more data examples (328);
wherein the one or more predetermined conditions comprise at least one of:

a startup process of the industrial system (114);
a shutdown process of the industrial system (114);
a calibration mode of a component of the industrial system (114); and
a data signal having a current or voltage outside an expected current range or voltage range.

15. A computing system (702) comprising:

one or more processors (706); and
one or more non-transitory computer-readable media that collectively store:

a machine-learned model (718); and
instructions that, when executed by the one or more processors (706), cause the computing system (702) to perform the method of anyone of the claims 1-9.

Input Data **102**

↓

Machine Learning System **104**

Reactant Amount Predictions
**106**

↓

Reactant Flow Control System
**108**

Reactant **110**

Catalytically Reduced
Emissions **116**

↑

Industrial System **114**

Selective Catalytic Reduction
System **112** → Exhaust System **118**

*FIG. 1*

Input Data **102**

Reactant Amount Data **226**

Machine Learning System **104**

Self-Adjusting Reactant Flow Control System **220**

Sensor Data **222**

Sensors **224**

Reactant **110**

Catalytically Reduced Emissions **116**

Industrial System **114**

Selective Catalytic Reduction System **112**

Exhaust System **118**

EP 4 660 428 A1

*FIG. 2*

Input Data **102**

Machine Learning System **304**

Stored Data Examples **328**

Nearest Neighbor Retrieval **330**

Retrieved Neighbor Data **332**

Neighborhood-based Inference **334**

Reactant Amount Predictions **106**

Reactant Amount Data **226**

Comparison System **338**

Surprising Examples **340**

EP 4 660 428 A1

*FIG. 3*

Input Data **102**

Machine Learning System **104**

Reactant Amount Predictions **106**

Reactant Amount Data **226**

Self-Adjusting Reactant Flow Control System **220**

Sensor Data **222**

Sensors **224**

Reactant **110**

Catalytically Reduced Emissions **116**

Industrial Turbine System **414**

Heat Recovery Steam Generator **444**

Gas Turbine **442**

Selective Catalytic Reduction System **112**

Exhaust Stack **418**

FIG. 4

**500**

502 — 
Obtaining, by a computing system comprising a machine-learned model, input data comprising one or more input values

504 — 
Retrieving, by the computing system based on the input data, two or more data examples indicative of prior reactant amounts

506 — 
Generating, by the machine-learned model based on the two or more data examples, output data indicative of an amount of a reactant

508 — 
Providing, by the computing system, a signal to cause the amount of the reactant to be provided to a selective catalytic reduction system

## FIG. 5

**600**

602 — Obtaining, by a self-adjusting reactant flow control system, emissions data indicative of one or more emissions amounts

604 — Adjusting, by the self-adjusting reactant flow control system based on the emissions data, a first amount of reactant provided to a selective catalytic reduction system

606 — Monitoring, by a computing system comprising one or more computing devices, the adjusting

608 — Determining that the first amount of the reactant provided to the selective catalytic reduction system has stabilized

610 — Training, by the computing system using one or more data examples comprising data indicative of the stabilized first amount, a machine learning system

*FIG. 6*

**Computing System 702**

**Computing Device 704**

Processor(s) 706

CPU(s) 708

ASIC(s) 710

Memory 712

Storage 714

Input/Output 716

Machine-Learned Model(s) 718

Computing Device 704

Computing Device 704

Computing Device 704

Computing Device 704

Computing Device 704

Computing Device 704

Computing Device 704

Computing Device 704

Network 720

Industrial Input Systems 722

Computing System(s) 724

Industrial Control Systems 726

**FIG. 7**

Europäisches
Patentamt

European
Patent Office

Office européen
des brevets

# EUROPEAN SEARCH REPORT

**Application Number**

EP 25 17 5371

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2021 209911 A1 (BOSCH GMBH ROBERT [DE]) 9 March 2023 (2023-03-09) * paragraphs [0079] - [0086], [0029]; claims 1-13; figures 1-7 * ----- | 1-15 | INV. F01N3/20 F01N9/00 |
| X | US 2009/293457 A1 (GRICHNIK ANTHONY J [US] ET AL) 3 December 2009 (2009-12-03) * claims 1-8; figure 1 * ----- | 1-15 | |
| X | CN 113 339 113 B (JIANGSU POWER DESIGN INST CO LTD CHINA ENERGY ENG GROUP ET AL.) 19 August 2022 (2022-08-19) * claims 1-7 * ----- | 1-15 | |

**TECHNICAL FIELDS SEARCHED (IPC)**

F01N

The present search report has been drawn up for all claims

| Place of search | Date of completion of the search | Examiner |
|---|---|---|
| Munich | 26 September 2025 | Seifert, Marco |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 5371

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2025

| Patent document cited in search report | Publication date | Patent family member(s) | Publication date |
|---|---|---|---|
| DE 102021209911 A1 | 09-03-2023 | CN    115795379 A<br>DE 102021209911 A1 | 14-03-2023<br>09-03-2023 |
| US 2009293457 A1 | 03-12-2009 | NONE | |
| CN 113339113 B | 19-08-2022 | NONE | |

EPO FORM P0459

For more details about this annex : see Official Journal of the European Patent Office, No. 12/82